# EUROPEAN PATENT APPLICATION

(11) **EP 4 760 457 A1**
(43) Date of publication of application: **17.06.2026**
(21) Application number: 25223806.8
(22) Date of filing: 16.12.2025
(51) Int. Cl.: G06F 1/20, F28F 3/02, H05K 7/20, H10W 40/00, H10W 40/22

(54) **COLD PLATE AND METHOD OF MANUFACTURING THE SAME**

(30) Priority: 16.12.2024 US 202463734697 P; 10.12.2025 US 202519415158
(71) Applicant: Vertiv Corporation, Westerville, OH 43082 (US)
(72) Inventor: Ratcliff, Gregory Wade, Westerville, 43082 (US); Busch, Gregory Thomas, Westerville, 43082 (US); Charapale, Utkarsh Diliprao, Westerville, 43082 (US)
(74) Representative: Cousens, Nico

(57) **Abstract**

A cold plate for removing heat from an electronic component in a data center is disclosed. The cold plate includes: a housing having one or more openings; fins enclosed in the housing, wherein each of the fins extends from top to bottom inside the housing and has an airfoil shape. The one or more openings include: an inlet for receiving fluid and an outlet for discharging fluid.

## Description

The present application claims the benefit under 35 U.S.C. § 119(e) of U.S. Provisional Patent Application Serial Number 63/734,697 filed December 16, 2024.

### TECHNICAL FIELD

The present disclosure relates to a cold plate, and more specifically, to a cold plate having airfoil-shaped fins for a data center cooling system.

### BACKGROUND

Buildings or facilities with large numbers of electronic devices consume a large amount of electric power. Electronic devices generate undesirably high heat when in use, which must be removed to prevent a failure of the devices. Among various buildings or facilities, data centers have ever-rising heat density, especially since the introduction of generative artificial intelligence (AI), requiring thermal systems to provide increased cooling density as demands for computing power continue to grow. One common electronic device or server cooling method includes an air-cooling method. For instance, server racks have been cooled using air-based thermal management technologies. However, air cooling is insufficient for cooling next-generation servers.

Server cooling in data centers is thus transitioning from air cooling to more efficient fluid cooling solutions. Fluid cooling also known as liquid cooling can bring several benefits including reducing energy costs, reducing the carbon footprint, increasing power density, targeted cooling options, and significantly improved heat transfer, thus greatly enhancing energy efficiency. Moreover, efficient cooling allows for more powerful server components, including higher processor clock speeds, substantially increasing power density within servers and entire data centers.

Liquid cooling systems include chip-scale cold plate liquid cooling systems and immersion liquid cooling systems. The cold plate-type liquid cooling system is directly provided with a metal cavity on the server chip, and the direct cooling of the chip is realized through the circulating flow of cooling liquid. Direct-to-chip cooling integrates the cooling system directly into the chassis of the computer. Cool liquid is piped to cold plates that sit directly next to components such as central processing units (CPUs), graphics processing units (GPUs), memory cards, and the like. Small fluid channels can carry the cool liquid to each plate, where the liquid draws off the heat from the underlying components. The warm liquid is then circulated to a cooling device or heat exchanger. After it has been cooled, the liquid is then circulated back to the cold plates.

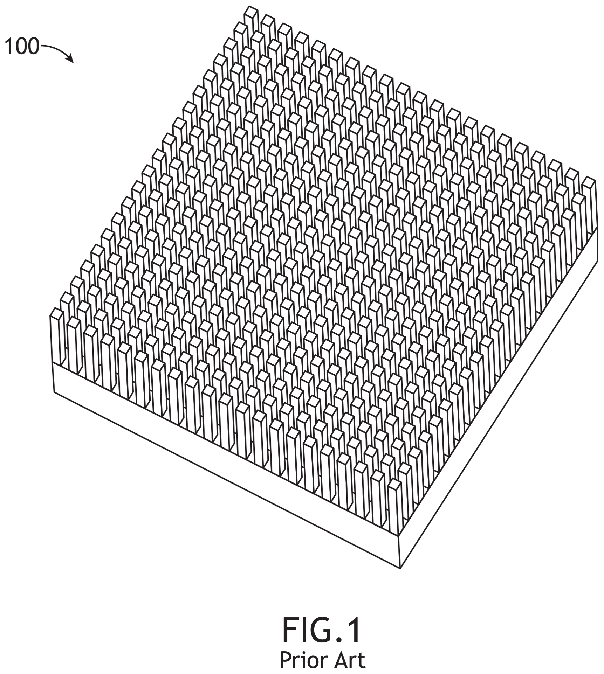

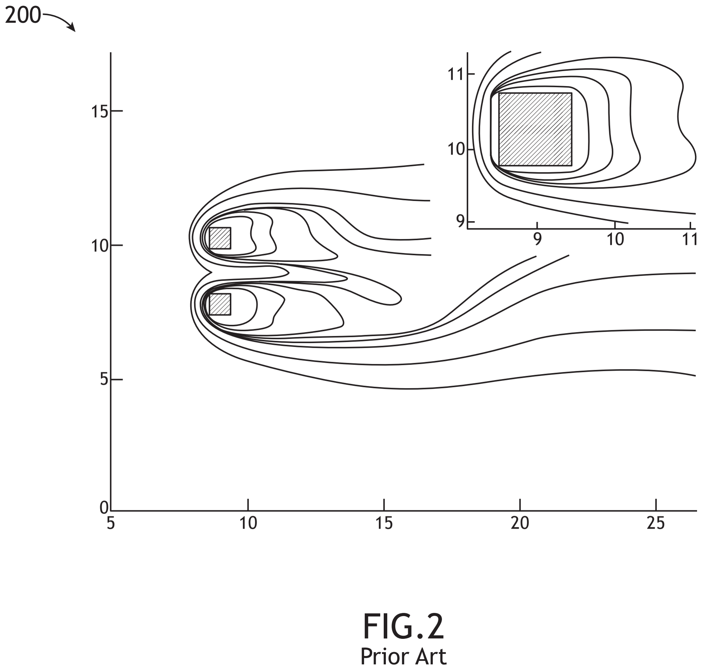

Several factors impact the performance and desirability of cold plates, and different factors are important for different uses. Some important factors include the cost of production and the ease of producing relatively large quantities. In addition, the cold plate heat exchange structures usually use a large heat transfer surface area, which often takes the form of fins, the geometry of which dictates cold plate performance. Traditional cold plate fins are square, triangle, or cylinder-shaped, but these blunt shapes often cause regions of flow separation, resulting in decreased cold plate performance. This can be especially detrimental in two-phase flows, where complete vaporization of the cooling fluid can occur on the rear surface of the fin, causing dry-out and effectively eliminating its ability to transfer heat in that region. For instance, FIG. 1 shows an internal structure 100 of an example cold plate according to conventional designs. This example shows an internal structure 100 of fins each having a cross-sectional shape that is a rectangular-shaped prism (e.g., cuboid). With such shaped fins, flow separation may be created on the downstream side of the fin as shown in the simulation 200 in FIG. 2, reducing liquid-cooling effectiveness during operation.

Therefore, what is needed is a cooling solution to improve heat transfer as the fluid passes through a cold plate. Further, what is needed is a low-cost liquid-cooled cold plate that can be in thermal contact with the heat-producing components/devices, while reducing energy costs in the use of high power next generation electronics.

### SUMMARY

Embodiments described herein relate to cold plate structures. In particular, the present disclosure relates to the internal structure of a cold plate for high-power next-generation electronic products and its manufacturing method while reducing energy costs compared to existing technologies. It also opens up new market opportunities that can meet thermal performance requirements that cannot be met by existing cooling plates. In addition, using these cooling plates can improve the power usage effectiveness (PUE) of data centers, which is a metric used to measure efficiency in almost all data centers and an important driving force in the selection of cooling equipment.

Additionally, this technology can be applied to other heat sink types, including air systems where natural convection is utilized, including but not limited to power panels, circuit breaker panels, and other systems.

A cold plate for removing heat from an electronic component is disclosed in accordance with one or more illustrative embodiments of the present disclosure. In one illustrative embodiment, the cold plate includes a housing including one or more openings. In another illustrative embodiment, the cold plate includes a plurality of fins enclosed in the housing. In another illustrative embodiment, each of the plurality of fins extends from top to bottom inside the housing and has an airfoil shape. In another illustrative embodiment, the plurality of fins are spaced apart from each other.

In a further aspect, the one or more openings may include an inlet for receiving fluid and an outlet for discharging the fluid.

In a further aspect, the plurality of fins may be arranged in the housing such that spaces lacking fins are defined to correspond to and align with the inlet and the outlet, respectively, of the housing.

In a further aspect, the inlet and the outlet may be defined on a same surface of the housing.

In a further aspect, the inlet and the outlet may be defined on different surfaces of the housing.

In a further aspect, each of the plurality of fins may be arranged such that a pointed end of the airfoil shape is directed toward the outlet.

In a further aspect, the plurality of fins may be integrated with the housing as one unitary body.

In a further aspect, the housing may have a lower body and an upper body, which are configured to be assembled.

In a further aspect, the plurality of fins and the housing may be formed of a same material.

In a further aspect, the plurality of fins and the housing may be formed of different materials from each other.

A method of manufacturing the cold plate is disclosed in accordance with one or more illustrative embodiments of the present disclosure. In one illustrative embodiment, the method includes forming a lower body of the housing. In another illustrative embodiment, the method includes upon completion of the lower body, continuously forming the plurality of fins and sides of the housing. In another illustrative embodiment, the method includes upon completion of the plurality of fins and the sides of the housing, continuously forming an upper body of the housing. In another illustrative embodiment, the housing and the plurality of fins are integrated as one unitary body.

In a further aspect, the forming of the lower body, the forming of the plurality of fins and the sides, and the forming of the upper body may each include three-dimensional (3D) printing.

In a further aspect, the one or more openings may include an inlet for receiving fluid and an outlet for discharging the fluid.

In a further aspect, the plurality of fins may be arranged in the housing such that spaces lacking fins are defined to correspond to and align with the inlet and the outlet, respectively, of the housing.

In a further aspect, the inlet and the outlet may be defined on a same surface of the housing.

In a further aspect, the inlet and the outlet may be defined on different surfaces of the housing.

In a further aspect, each of the plurality of fins may be arranged such that a pointed end of the airfoil shape is directed toward the outlet.

A method of manufacturing the cold plate is disclosed in accordance with one or more illustrative embodiments of the present disclosure. In one illustrative embodiment, the method includes forming the housing having a lower body and an upper body. In another illustrative embodiment, the method includes forming the plurality of fins. In another illustrative embodiment, the method includes assembling the housing and the plurality of fins.

In a further aspect, the plurality of fins may be arranged in the housing such that spaces lacking fins are defined to correspond to and align with the inlet and the outlet, respectively, of the housing.

In a further aspect, each of the plurality of fins may be arranged such that a pointed end of the airfoil shape is directed toward the outlet.

Other aspects and advantages of the disclosure will become apparent from the following detailed description, taken in conjunction with the accompanying drawings, illustrating by way of example the principles of the disclosure. This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are exemplary and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1 shows an internal structure of an example cold plate according to a prior art.
FIG. 2 shows a flow field around fins of the internal structure of FIG. 1.
FIG. 3 shows a perspective view of a cold plate, in accordance with one or more embodiments of the present disclosure.
FIG. 4 shows an internal structure of the cold plate, in accordance with one or more embodiments of the present disclosure.
FIG. 5A shows a side and top view of the internal structure of the cold plate, in accordance with one or more embodiments of the present disclosure.
FIG. 5B shows airfoil-shaped fins along with representative streamlines of fluid flow along fin surfaces, in accordance with one or more embodiments of the present disclosure.
FIG. 6 shows a computational fluid dynamics (CFD) analysis of the flow of the cold plate, in accordance with one or more embodiments of the present disclosure.
FIG. 7A shows an enlarged view of the flow streamlines of the CFD analysis of FIG. 6, in accordance with one or more embodiments of the present disclosure.
FIG. 7B shows a CFD analysis of the internal structure of the conventional cold plate of FIG. 1.
FIG. 8 shows a flow chart for a method of manufacturing the cold plate, in accordance with one or more embodiments of the present disclosure.

### DETAILED DESCRIPTION

The figures described above and the written description of specific structures and functions below are not presented to limit the scope of what Applicant has invented or the scope of the appended claims. Rather, the Figures and written description are provided to teach any person skilled in the art to make and use the inventions for which patent protection is sought. Those skilled in the art will appreciate that not all features of a commercial embodiment of the disclosures are described or shown for the sake of clarity and understanding. Persons of skill in this art will also appreciate that the development of an actual commercial embodiment incorporating aspects of the present disclosures will require numerous implementation-specific decisions to achieve the developer's goal for the commercial embodiment. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the inventions disclosed and taught herein are susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the disclosures or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

It is known that data center equipment generates a significant amount of heat that must be controlled by various means to maintain the data center equipment in working order. While it is not practical to include an exhaustive list of the function and type of equipment that might be found in a data center of a business or other organization, for purposes of this disclosure, the term "data center equipment" or like term will be used to refer to any type of heat generating component that one may find useful to locate within a protected environment of an organization's data center or other facility for the collection and installation of computer systems, electronics, or controls. Such data center equipment typically includes, but is not limited to, computer systems, electronics, data storage systems, communications equipment, networking equipment, information technology equipment, and components and parts therefor, such as, but not limited to, servers, chips, processors, motherboards, sound cards, graphics cards, memory devices, data storage devices, modems, and any other equipment or component that now or may in the future be found useful in the field.

As noted above, air-based cooling technologies are limited in their heat transfer capabilities, so liquid-cooled technologies may be needed for the thermal management of high-power, next-generation electronics. One such liquid-cooled technology is a cold plate. Cold plates typically include hollow plates, hollow channels, and/or the like with high thermal conductivity through which a cooling fluid is circulated. The cold plate is often mounted directly to a heat-generating device, such as a CPU or GPU. The device heats the cold plate, which transfers the heat to the cooling fluid. Typically, the fluid transfers the heat outside of the immediate electronics/cold plate environment to a separate heat rejection unit. The fluid may remain in the same phase as it is heated in the cold plate (e.g., it may enter the cold plate in the form of a liquid and leave as a liquid), or it may change phase as it is heated (e.g., change from a liquid to a vapor). Flows through cold plates where phase change occurs are known as two-phase flows and flows that remain in a single state are known as single-phase.

When designing a cold plate, many factors affect its performance. The present disclosure is directed to internal structures that boost heat transfer and improve capacity. The shape of these structures may significantly improve cold plate performance for a given set of thermal capacity and power requirements. Often the structures of cold plates take the form of internal fins in thermal communication with the cooling fluid, where the geometry, density, and arrangement of such fins dictate cold plate performance.

The internal fin structure of the cold plate described herein may have a teardrop shape (e.g., airfoil shape) such as used for aircraft wings or the like.

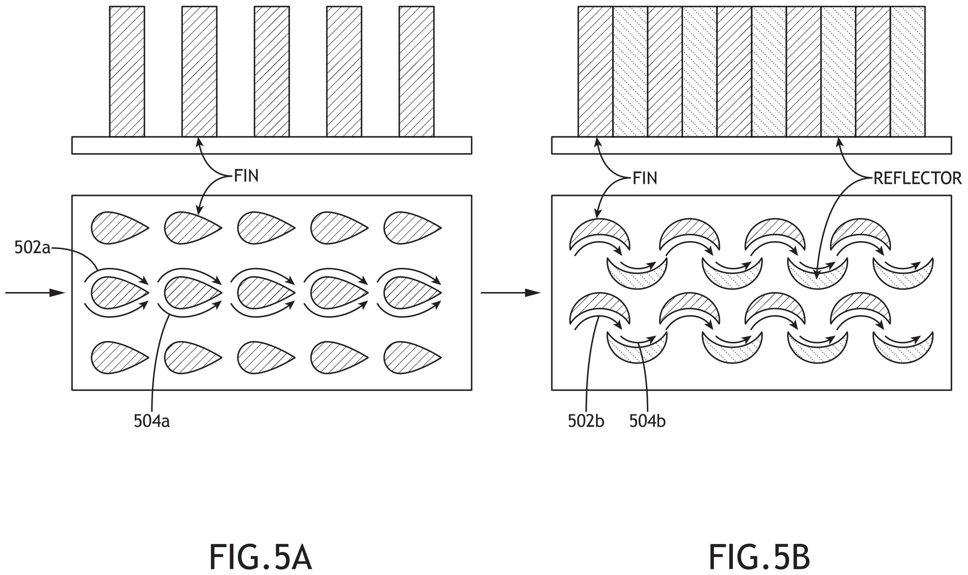

Note that for purposes of the present disclosure, the term "airfoil", "airfoil shape", and the like includes, unless otherwise noted, an airfoil shape with any amount or no amount of camber (i.e., zero camber). For example, being cambered means the airfoil is curved (e.g., U-shaped or the like) by some amount (e.g., 5 degrees), where a forward and rearward are angled (e.g., as measured between two tangents of two points along a camber line of their cross-sectional shape) by a non-zero angle. The "airfoil" may include any suitable shape such as a teardrop shape having a rounded head (i.e., leading edge) and a tapered (i.e., pointed) tail (i.e., trailing edge). As shown in FIG. 5A, the airfoil shape may be completely symmetrical with zero camber. As shown in FIG. 5B, the airfoil shape may include some camber (e.g., non-zero camber, such as at least 40 degrees of camber). As shown in FIG. 5B, in contrast to a rounded leading edge, the shape of the fins may be relatively pointed at the leading edge.

The airfoil shape may include a thickness located between about 20% and 40% of chord length.

Such a shape can prevent regions of flow separation and dryout behind each fin, increasing heat transfer potential and decreasing pressure drop through the cold plate. Compared with a cylindrical or rectangular-shaped fin, an airfoil-shaped fin can have, e.g., ten times less flow resistance for a given cross-section and double the heat transfer surface area, improving heat transfer capacity and cold plate power requirements at the same time.

The example embodiments proposed herein can apply to either single-phase or two-phase cold plates, but are contemplated for exemplary use with two-phase cooling.

Air or other gases could be used as the cooling medium in a cold plate. Liquid cooling is, however, generally used since liquid is denser than gas so more thermal mass is available to absorb heat from the electronic equipment. Also, liquid has higher thermal conductivities so heat can transfer more rapidly than heat will transfer through gas. Furthermore, liquid can absorb and transfer more heat than a comparable amount of gas.

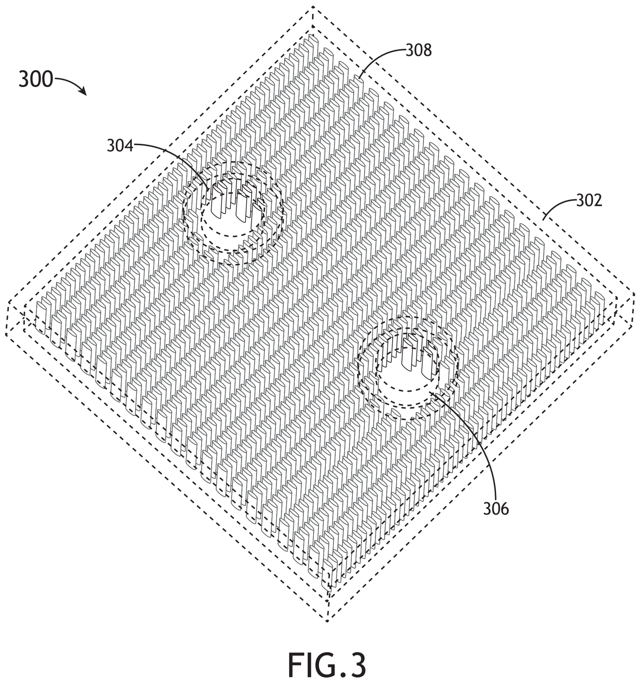

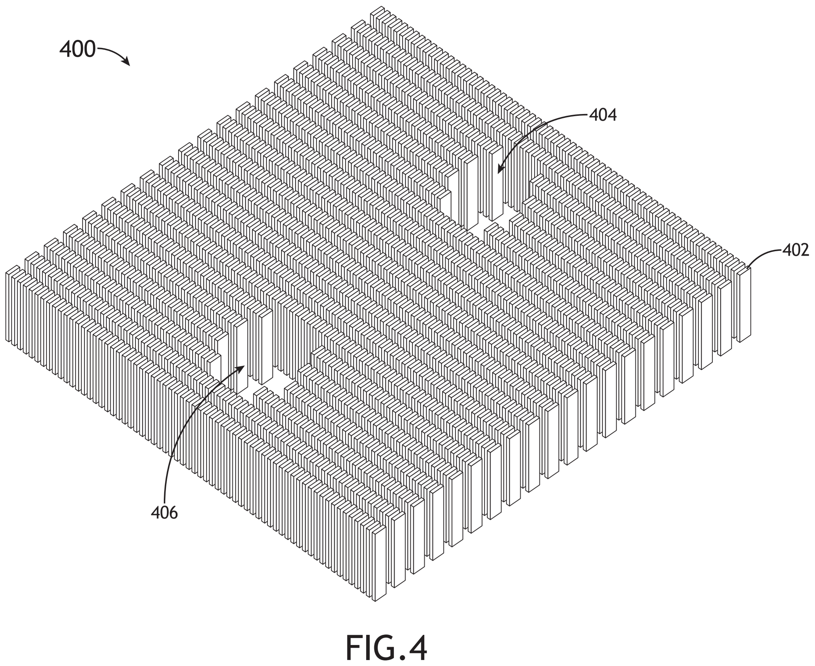

FIG. 3 shows a perspective view of a cold plate 300, in accordance with one or more embodiments of the present disclosure. FIG. 4 shows an internal structure 400 of the cold plate 300 of FIG. 3, in accordance with one or more embodiments of the present disclosure.

In some embodiments, the cold plate 300 includes a housing 302, or enclosure, having one or more openings. For instance, the openings may include an inlet 304 for receiving fluid and an outlet 306 for discharging fluid. The inlet 304 and the outlet 306 may be formed on the top of the housing 302 as shown. However, the locations of the inlet 304 and the outlet 306 are not limited thereto. The inlet 304 and the outlet 306 may be formed on the sides or bottom of the housing 302, alternatively, one opening on the top and the other opening on the side or bottom may be formed, or the like. The position of these openings may influence the flow pattern inside the housing 302. In addition, the shapes of such openings may be formed to correspond to the flow supply and discharge lines. In some embodiments, the flow pattern will tend to follow the supply and discharge lines, but some structures within the housing 302 can alter the flow pattern.

The cold plate 300 may further include an internal structure 308. The internal structure 308 may be integrally formed with the housing 302 as a unitary body. Alternatively, the housing 302 and the internal structure 308 may be formed separately and attached to each other. The internal structure 308, which is described in detail further below, may include fins which tightly contact (e.g., no gaps relative to) the top and bottom inner surfaces of the housing 302.

In addition, the housing 302 and the internal structure 308 may be formed of the same material or different materials from each other. For instance, the housing 302 and the internal structure 308 may be formed of a polymer-based material, such as a thermoplastic or thermosetting resin. However, other materials may also be used, such as copper, aluminum, titanium, steel, gold, or even non-metallic materials such as graphite or a ceramic.

The fins of the internal structure 308 may be arranged in any suitable arrangement known in the art or disclosed herein. In some embodiments, the fins may be spaced apart from each other in a regular pattern (e.g., grid-like, and/or repeating pattern) as shown in the drawings. In some embodiments, the fins may be arranged in an irregular pattern (e.g., non-repeating).

FIG. 4 shows the internal structure 400 of the cold plate 300, in accordance with one or more embodiments of the present disclosure. The internal structure 400, which corresponds to the internal structure 308 of FIG. 3, may include fins 402. The size and number of fins 402 may vary, and the fins may be arranged in rows and columns.

As shown, there may be spaces/openings 404, 406 (e.g., areas lacking fins 402, such as areas defined by the absence of fins 402) which may respectively correspond to and align with the inlet 304 and the outlet 306 of the housing 302 so as to allow fluid flow therethrough without interference. For example, as shown, fewer or no fins 402 may be located proximate to the openings.

FIG. 5A shows a side and top view of the internal structure of the cold plate, in accordance with one or more embodiments of the present disclosure. FIG. 5B shows airfoil-shaped fins along with representative streamlines of fluid flow along fin surfaces, in accordance with one or more embodiments of the present disclosure.

As shown in FIGS. 5A and 5B, a cold plate having airfoil-shaped fins may promote attached flow (e.g., prevent detached flow) while reducing drag force. For example, attached flow may be characterized by fluid streamlines that remain in close proximity to the surface throughout the flow path, where the boundary layer remains attached without separation. For instance, first flow 502a flowing over one surface of an airfoil-shaped fin can continue the streamlined flow movement to an adjacent, aligned fin, in a same row. Similarly, a second flow 504a may continue from fin to fin on the other opposing side of the fins. Fluid streamlines 502b, 504b of FIG. 5B also illustrate attached flow. Airfoil streamlines are traced along the path around the airfoil where the velocity is tangential. The advantages of creating these airfoil patterns may be similar to those in other applications such as airplane wings. Embodiments may include continuously disposed and aligned airfoil-shaped fins to create various continuous airfoil streamline patterns, which may contrast with the flow separation formed by conventional fins of a cold plate such as noted earlier with respect to FIG. 2. The continuous airfoil streamline patterns may maintain laminar flow characteristics through multiple rows of fins, thereby reducing turbulent mixing losses. For example, the Reynolds number of the flow may be maintained below threshold values to preserve laminar boundary layer attachment along the fin surfaces.

Referring to FIG. 5B, the fins of the internal structure may be configured to direct fluid streamlines 502b, 504b that alternate direction slightly (e.g., curve in a first direction and curve in a second opposing/flipped direction). This may, in a sense, reflect (i.e., re-direct) the streamlines 502b, 504b. For example, the fins in adjacent rows may be staggered along the direction of flow such that the streamline exiting a trailing edge of a fin of a first row of fins is directed towards a leading edge (e.g., just inside leading edge) of a fin of a second row of fins. This may repeat using curved fins, back and forth, continuously, along the direction of the flow. The fins in the two adjacent rows may include opposing concave surfaces to cause a plurality of redirections (e.g., reflections).

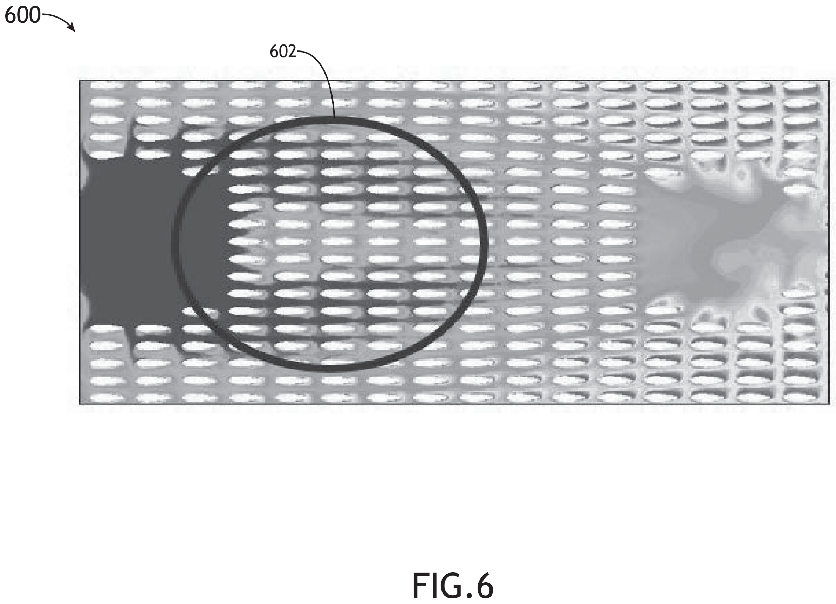

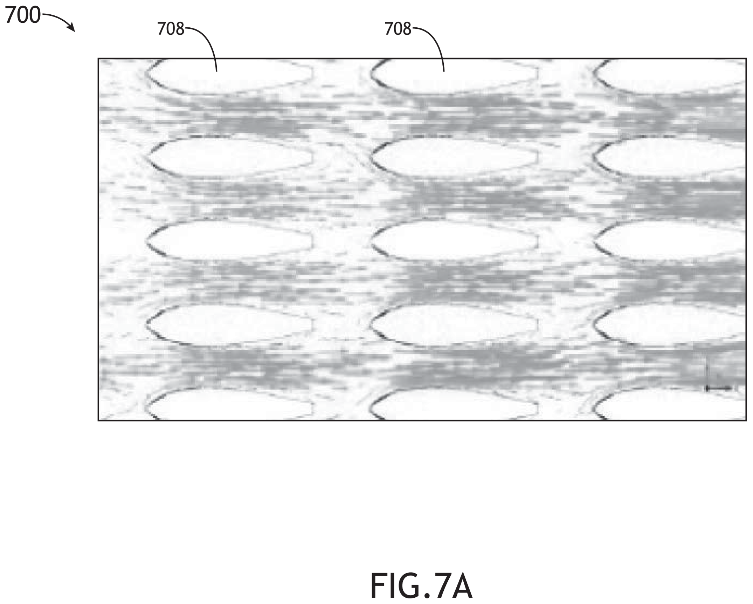

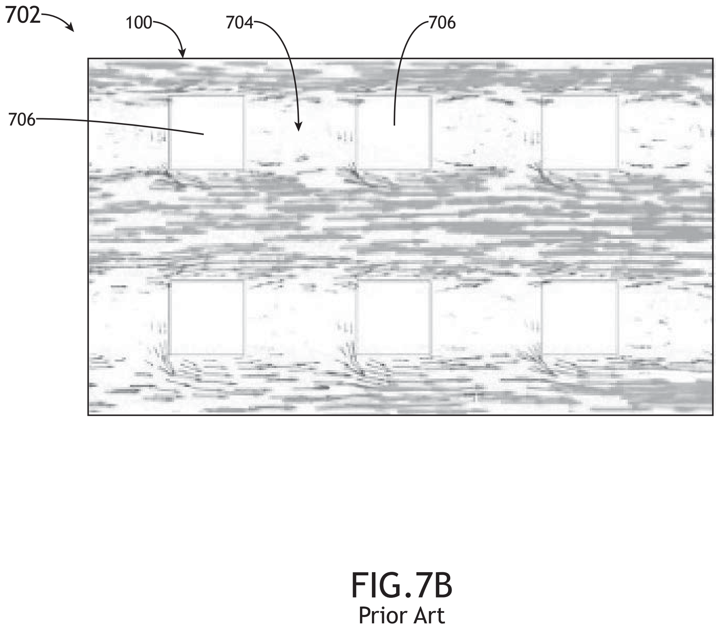

FIGS. 6, 7A, and 7B further support the advantages of the airfoil-shaped fins.

For instance, FIG. 6 shows a computational fluid dynamics (CFD) analysis 600 of the flow of the cold plate, in accordance with one or more embodiments of the present disclosure. As shown, in a relatively higher flow area 602, the flow shows reduced detachment and improved cooling compared to the simulation 200 of FIG. 2.

FIG. 7A shows an enlarged view of the flow streamlines 700 corresponding to the CFD analysis of FIG. 6, in accordance with one or more embodiments of the present disclosure. FIG. 7B shows a CFD analysis 702 of the internal structure 100 of the conventional cold plate of FIG. 1.

In particular, FIGS. 7A and 7B compare embodiments (e.g., fins 708 having an airfoil-shape) of the present disclosure with a conventional structure (e.g., rectangular-shaped fins 706). As shown, a dry area 704 (i.e., an area through which little liquid passes) of the conventional internal structure 100 may significantly lower an amount of surface area of the rectangular-shaped fins 706 usable for heat transfer. In contrast, embodiments of the present disclosure, as shown in FIG. 7A, may increase the surface area of the fins 708 available to provide cooling to the cold plate and/or heated servers that require cooling.

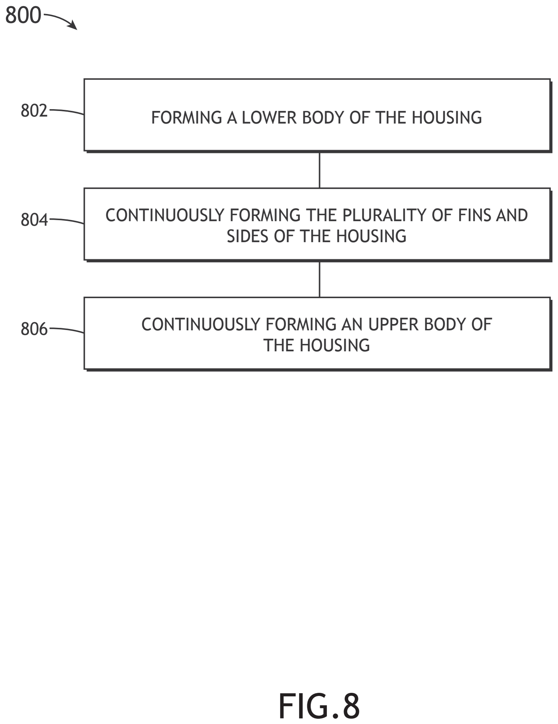

FIG. 8 shows a flow chart for a method 800 of manufacturing the cold plate, in accordance with one or more embodiments of the present disclosure. The cold plate 300 is an exemplary vehicle for carrying out method 800. However, the method 800 is not necessarily limited to the foregoing embodiments and, unless otherwise noted, should extend to any acceptable systems or devices now or hereafter known to those skilled in the art.

The method 800 may include a step 802 of forming a lower body of the housing 302. Referring back to FIG. 3, the housing 302 may have a cubical shape having six walls/bodies, such as an upper, lower, and four side bodies. The lower body may have a flat rectangular shape.

The method 800 may include a step 804 of continuously forming fins on the lower body. Here, the lower body and the fins may be integrally formed as one body, as well as side bodies (e.g., four outer sides) of the housing 302 such that the fins and side bodies may be formed together. The continuous formation may be achieved through layer-by-layer additive manufacturing processes where each successive layer bonds to the previous layer.

The method 800 may include a step 806 of continuously forming an upper body of the housing.

The housing and the fins may be formed by any suitable method such as injection molding or three-dimensional (3D) printing, together as one unitary body or separately. This simple manufacturing process makes it possible to reduce cost and time, as well as promote an environmentally friendly manufacturing process by enabling the recycling and repurposing of materials, reduced use of water/coolant, using biodegradable filaments, and/or the like.

Each of the components and their constituent parts, and other variations described herein may include corresponding features described with reference to each of the other components and features described without limitation.

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "in embodiments", "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

It is to be understood that embodiments of the methods disclosed herein may include one or more of the steps described herein. Further, such steps may be carried out in any desired order and two or more of the steps may be carried out simultaneously with one another. Two or more of the steps disclosed herein may be combined in a single step, and in some embodiments, one or more of the steps may be carried out as two or more sub-steps. Further, other steps or sub-steps may be carried in addition to, or as substitutes to one or more of the steps disclosed herein.

Components illustrated and described herein are merely examples of a system/device and components that may be used to implement embodiments of the inventive concepts and may be replaced with other devices and components without departing from the scope of the claims. Furthermore, any dimensions, degrees, and/or numerical ranges provided herein are to be understood as non-limiting examples unless otherwise specified in the claims.

## Claims

1. A cold plate (300) for removing heat from an electronic component, comprising:
a housing (302) comprising one or more openings; and
a plurality of fins (402) enclosed in the housing,
wherein each of the plurality of fins extends from top to bottom inside the housing and has an airfoil shape, and
wherein the plurality of fins are spaced apart from each other.

2. The cold plate of claim 1, wherein the one or more openings comprise:
an inlet (304) for receiving fluid; and
an outlet (306) for discharging the fluid.

3. The cold plate of claim 2, wherein the plurality of fins are arranged in the housing such that spaces lacking fins are defined to correspond to and align with the inlet and the outlet, respectively, of the housing.

4. The cold plate of claim 2 or 3, wherein the inlet and the outlet are defined on a same surface of the housing, or wherein the inlet and the outlet are defined on different surfaces of the housing.

5. The cold plate of any of claims 2 to 4, wherein each of the plurality of fins is arranged such that a pointed end of the airfoil shape is directed toward the outlet.

6. The cold plate of any preceding claim, wherein the plurality of fins are integrated with the housing as one unitary body, and/or wherein the housing has a lower body and an upper body, which are configured to be assembled.

7. The cold plate of any preceding claim, wherein the plurality of fins and the housing are formed of a same material, or wherein the plurality of fins and the housing are formed of different materials from each other.

8. The cold plate of any preceding claim, wherein two adjacent rows comprising a first row of fins and a second row of fins of the plurality of fins are staggered along a direction of flow to cause a plurality of redirections between the two adjacent rows such that a streamline exiting a trailing edge of each fin of the first row of fins is directed toward a leading edge of a respective fin of the second row of fins, wherein each fin of the first row of fins and each fin of the second row of fins include a concave surface to cause the plurality of redirections between the two adjacent rows.

9. A method (800) of manufacturing the cold plate of claim 1, the method comprising:
forming (802) a lower body of the housing;
upon completion of the lower body, continuously forming (804) the plurality of fins and sides of the housing; and
upon completion of the plurality of fins and the sides of the housing, continuously forming (806) an upper body of the housing,
wherein the housing and the plurality of fins are integrated as one unitary body.

10. The method of claim 9, wherein the forming of the lower body, the forming of the plurality of fins and the sides, and the forming of the upper body each comprise three-dimensional (3D) printing.

11. The method of claim 9 or 10, wherein the one or more openings comprise:
an inlet for receiving fluid; and
an outlet for discharging the fluid.

12. The method of claim 11, wherein the plurality of fins are arranged in the housing such that spaces lacking fins are defined to correspond to and align with the inlet and the outlet, respectively, of the housing, and/or wherein the inlet and the outlet are defined on a same surface of the housing.

13. The method of claim 11 or 12, wherein the inlet and the outlet are defined on different surfaces of the housing, and/or wherein each of the plurality of fins is arranged such that a pointed end of the airfoil shape is directed toward the outlet.

14. A method of manufacturing the cold plate of any of claims 1 to 8, the method comprising:
forming the housing having a lower body and an upper body;
forming the plurality of fins; and
assembling the housing and the plurality of fins.

15. The method of claim 14, wherein the plurality of fins are arranged in the housing such that spaces lacking fins are defined to correspond to and align with an inlet and an outlet, respectively, of the housing.
